# FASCICULE DE BREVET EUROPEEN

(11) **EP 0 620 596 B1**
(45) Date de publication et mention de la délivrance du brevet: **12.08.1998**
(21) Numéro de dépôt: 94410026.2
(22) Date de dépôt: 11.04.1994
(51) Int. Cl.: H01L 23/528, H01L 27/102

(54) **Réseau de diodes monolithique**
Monolithisches Diodengitter
Monolithic diode grid

(30) Priorité: 13.04.1993 FR 9304586
(43) Date de publication de la demande: 19.10.1994
(73) Titulaire: SGS-THOMSON MICROELECTRONICS S.A., 94250 Gentilly (FR)
(72) Inventeur: Pezzani, Robert, F-37210 Vouvray (FR)
(74) Mandataire: de Beaumont, Michel

(56) Documents cités:
- EP-A- 0 318 404

## Description

La présente invention concerne la réalisation d'un réseau de diodes de protection.

Dans de nombreuses configurations pratiques, on est amené à réaliser des réseaux de diodes de protection tels que celui illustré en figure 1A dans lequel des diodes D1-1, D1-2, D1-3, ... D1-n ont des premières bornes T1-1 T1-2, T1-3, ... T1-n, respectivement reliées à des lignes à protéger et une deuxième borne commune T2 reliée à un potentiel de référence tel que la masse ou à une autre ligne. Dans l'exemple représenté et dans la suite du texte, on considèrera le cas où toutes les diodes ont une cathode commune mais il sera clair que le réseau symétrique dans lequel les anodes sont communes et les cathodes sont reliées individuellement à des lignes à protéger peut être réalisé de façon similaire.

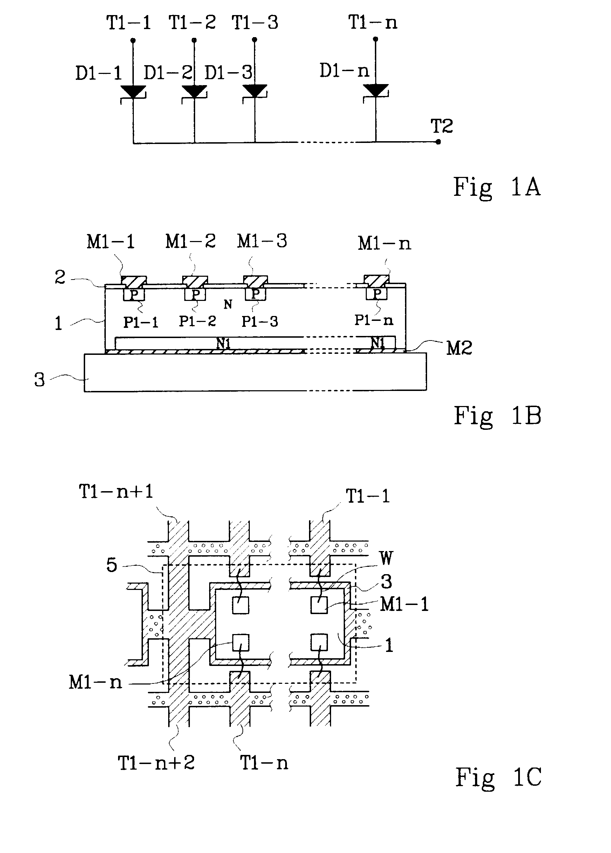

La façon la plus classique de réaliser sous forme de composant monolithique un réseau de diodes tel que celui de la figure 1A est illustrée en coupe en figure 1B. Le réseau est réalisé sous forme d'un composant semiconducteur monolithique dans un substrat 1 de type N. A la surface du substrat 1 sont formées des régions de type de conductivité opposées P1-1, P1-2, P1-3, ... P1-n. Du côté de la face inférieure du substrat 1 est formée une région de type N fortement dopée N1. La face supérieure du composant est revêtue d'une couche isolante, classiquement une couche d'oxyde de silicium 2, et des métallisations M1-1, M1-2, M1-3, ... M1-n sont en contact avec chacune des régions P1-1 à P1-n. Une métallisation M2 est formée sur la face arrière en contact avec la région N1. Chacune des métallisations M1-1 à M1-n constitue l'anode de l'une des diodes D1 à Dn et la métallisation de face arrière M2 constitue la cathode commune de toutes ces diodes. Classiquement, le composant est monté, par exemple par brasure, sur une embase métallique 3.

Comme le représente très schématiquement la figure 1C, en vue de dessus, de façon usuelle, l'embase métallique 3 sur laquelle est monté le composant 1 fait partie d'une grille de connexion. Cette grille est une plaque métallique découpée de façon appropriée pour comprendre l'embase 3, des languettes T1-1 à T1-n+2 formant cosses de connexion (marquées par des hachures dans la figure) et des éléments de liaison (marqués par des cercles dans la figure) uniquement destinés à assurer le maintien mécanique de la grille pendant la phase de connexion. Cette phase de connexion consiste à relier par un fil W, couramment un fil d'or, chacune des plages de métallisation M1-1 à M1-n de la puce à une extrémité d'une languette formant cosse T1 à T1-n. Les deux dernières cosses T1-n+1 et T1-n+2 constituent des prolongements de l'embase 3. En effet, les machines de soudage de fil entre deux points (une cosse et une métallisation) sont des machines très sophistiquées et très précises et il s'avère très difficile de régler ces machines pour qu'elles effectuent certaines soudures entre des points à un niveau de dénivelé déterminé (une cosse et la surface supérieure d'une puce) et des points à un autre niveau de dénivelé ou au même niveau (une cosse et l'embase).

Une fois une puce soudée à l'embase d'une grille de connexion et ses plages de métallisation reliées par des fils d'or à des éléments formant cosse de oette grille, la puce est noyée dans de la matière plastique, par exemple selon le contour marqué par le trait en pointillés 5 de la figure 1C, puis les éléments de liaison entre cosses de la grille de connexion (régions marquées par des cercles en figure 1C) sont découpés et éliminés. La représentation de la figure 1C est très fortement schématique et uniquement destinée à illustrer le problème posé que la présente invention vise à résoudre. Le boîtier utilisé pourra en pratique être un boîtier à deux rangées de cosses tel qu'un boîtier SO20.

Pour des raisons qui se comprennent bien en regardant la vue de dessus de la figure 1C, le contact de cathode qui correspond à l'embase 3 est pratiquement inévitablement relié à des cosses extrêmes, par exemple la cosse T1-n+2 et la cosse en regard. Ces bornes de cathode (une seule pourrait être prévue mais on en prévoit généralement deux) sont souvent reliées à la masse et, pour des raisons pratiques, l'utilisateur peut souhaiter que ces bornes de masse soient situées au niveau de cosses particulières, par exemple la troisième cosse d'un côté et la septième de l'autre et non pas au niveau des cosses extrêmes (les cosses 10 et 20 ou 1 et 11 dans le cas d'un boîtier comprenant dix cosses de chaque côté). La structure de la figure 1C se prête très mal à un tel montage.

De plus, la technique de fabrication des composants semiconducteurs a beaucoup évolué au cours du temps. Alors que les diverses opérations d'implantation et de diffusion dans une puce de semiconducteur sont de manière théorique les opérations les plus complexes et celles qui confèrent sa fonction au composant, l'ensemble de ces opérations (couramment appelées dans la technique opérations de FRONT END ou opérations initiales) est maintenant souvent moins coûteux que les opérations de montage de la puce et de mise en boîtier de celle-ci (couramment appelées dans la technique opérations de BACK END ou opérations finales). Il est maintenant souvent plus économique de rendre plus complexe la structure de diffusion dans le silicium pour simplifier le montage et l'on réduit alors le coût d'ensemble du composant.

Ainsi, un objet de la présente invention est de prévoir un composant monolithique constituant un réseau de diodes qui se prête simplement à des opérations de montage dans lesquelles la ou les bornes communes puissent simplement être associées à une cosse quelconque d'un boîtier.

Un autre objet de la présente invention est de prévoir un tel composant dans lequel la résistance série des diodes soit minimisée.

Pour atteindre ces objets, la présente invention prévoit un composant semiconducteur selon la revendication 1.

Un composant semiconducteur intégrant un réseau de diodes de protection correspondant au préambule de la revendication 1 est décrit dans EP-A-0 318 404.

Selon un mode de réalisation de la présente invention on prévoit un composant semiconducteur formé dans une plaquette semiconductrice d'un premier type de conductivité comprenant une pluralité de premières zones du deuxième type de conductivité formées dans la face avant de la plaquette et revêtues de premières métallisations ; une deuxième zone du deuxième type de conductivité et une troisième zone du premier type de conductivité formées dans la face avant de la plaquette ; une deuxième métallisation en contact avec les deuxième et troisième zones ; une quatrième zone du premier type de conductivité formée dans la face arrière en face des premières et deuxième zones ; une cinquième zone du deuxième type de conductivité formée dans la face arrière en face de la troisième zone ; et une métallisation de face arrière, et en contact avec les quatrième et cinquième zones.

Selon un mode de réalisation de la présente invention, les premières zones s'étendent selon au moins une ligne le long d'un bord du composant et les deuxième et troisième zones s'étendent au moins selon des lignes parallèles à la première ligne.

Ces objets, caractéristiques et avantages ainsi que d'autres de la présente invention seront exposés en détail dans la description suivante de modes de réalisation particuliers faite en relation avec les figures jointes parmi lesquelles :
la figure 1A est un schéma d'un réseau de diodes de protection à cathode commune ;
la figure 1B est une vue en coupe illustrant un mode de réalisation classique sous forme de composant monolithique du réseau de diodes de la figure 1A ;
la figure 1C est une vue de dessus du composant de la figure 1B associé à une grille de connexion ;
la figure 2A représente une vue en coupe selon la ligne A-A de la figure 2B d'un mode de réalisation d'un réseau de diodes monolithique selon la présente invention ;
la figure 2B représente une vue de dessus selon le plan B-B de la figure 2A d'un composant selon la présente invention ;
la figure 2C représente une vue de dessus du composant de la figure 2A muni de ses métallisations ;
la figure 2D représente une vue de dessus du composant de la figure 2A selon le plan D-D ; et
la figure 3 représente un schéma équivalent d'un composant selon la présente invention.

Comme cela est usuel dans le domaine de la représentation des composants semiconducteurs, les diverses vues ne sont pas à l'échelle et, en particulier dans les vues en coupe, les épaisseurs des diverses couches ont été tracées arbitrairement pour faciliter la représentation.

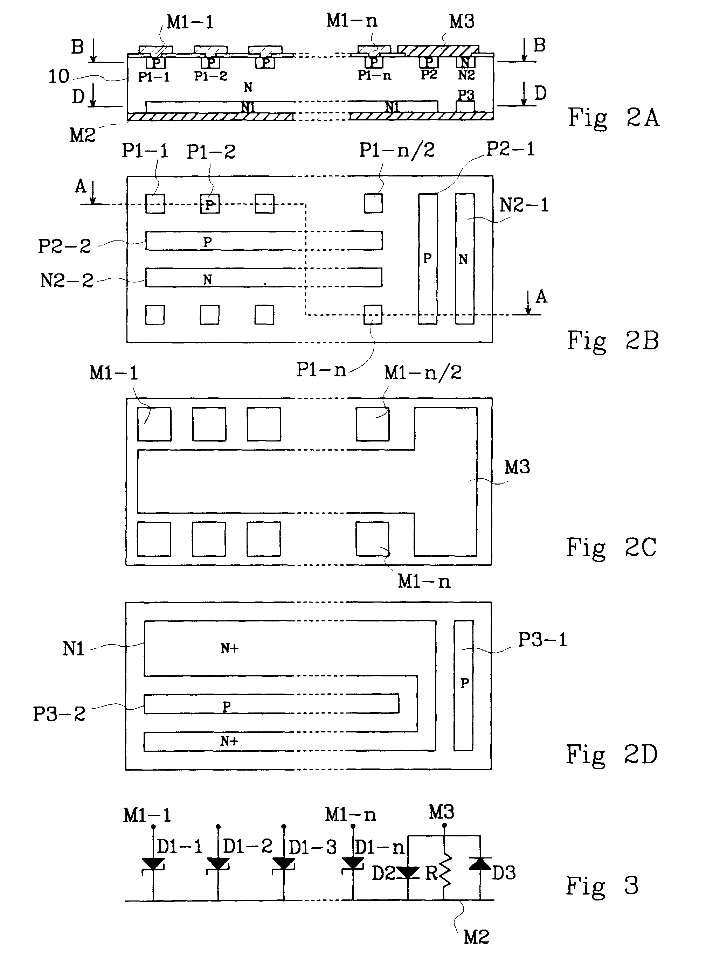

Comme le représente la vue en coupe de la figure 2A, un composant selon la présente invention est réalisé à partir d'un substrat semiconducteur 10, couramment du silicium, de type N faiblement dopé. Dans la face supérieure de ce substrat sont formées des régions diffusées P1-1 à P1-n de type P. Les niveaux de dopage des régions P1-1 à P1-n et du substrat 10 sont choisis pour obtenir des diodes à avalanche de tension de claquage choisie. Sous chacune des régions P1-1 à P1-n est formée à partir de la face inférieure du substrat une région N1 de type N fortement dopée. Les régions P1-1 à P1-n sont solidaires de métallisations M1-1 à M1-n et la face inférieure du substrat est solidaire d'une métallisation M2.

Tel qu'il a été décrit jusqu'ici, le composant selon l'invention est identique au composant selon l'art antérieur illustré en figure 1B. Le composant selon l'invention se distingue du composant antérieur par la prévision de couches supplémentaires et la configuration de ces couches.

Plus particulièrement, la face supérieure du substrat comprend une région supplémentaire de type P, P2, et une région supplémentaire de type N, N2. L'ensemble des régions P2 et N2 est solidaire d'une métallisation M3. La région P2 s'étend en face d'une portion de la région N1 et la région N2 s'étend en face d'une région de type P, P3, formée dans la face inférieure du substrat. La métallisation M2 recouvre aussi cette portion de la région N1 et la région P3.

Trois chemins relient dans le silicium la métallisation M2 à la métallisation M3. Un premier chemin part de la région N1 vers la région P2 et constitue une diode dont la cathode est reliée à la métallisation M2 et l'anode à la métallisation M3. Cette diode est désignée par la référence D2 dans le schéma équivalent de la figure 3. Un deuxième chemin part de la région P3 vers la région N2 et constitue une diode dont l'anode est reliée à la métallisation M2 et la cathode à la métallisation M3. Cette diode est désignée par la référence D3 dans le schéma équivalent de la figure 3. Un troisième chemin est constitué par la résistance R correspondant à l'épaisseur de substrat (moins l'épaisseur de la couche N2). En conséquence, quelle que soit la façon dont le composant selon l'invention est connecté et quelle que soit la polarité des connexions, les métallisations M2 et M3 sont à des potentiels qui ne diffèrent que de la chute de tension d'une diode connectée en direct (diode D2 ou D3). Ceci se voit bien dans le schéma de la figure 3.

Ainsi, la structure représentée en figure 2A et le schéma équivalent de la figure 3 permettent d'obtenir entre l'une ou l'autre des métallisations M1-i (i étant un entier compris entre 1 et n) et la métallisation M3 une diode de protection D1-i en série avec une diode directe. Toutes les métallisations à connecter se trouvent sur la face supérieure d'une puce semiconductrice et la face inférieure de cette puce est non connectée. Il sera alors plus facile de connecter une grille de connexion aux métallisations M1-1 à M1-n et à la métallisation M3 puisque toutes ces métallisations se trouvent à un même niveau sur une même face d'un composant.

Selon un autre aspect de la présente invention qui apparaît dans les vues de dessus des figures 2B à 2D, la métallisation M3 s'étend sur toute la longueur de la face supérieure de la puce, par exemple au centre de la puce si les métallisations supérieures M1-1 à M1-n des diodes individuelles sont disposées le long de la périphérie de la puce.

La figure 2B représente une vue de dessus prise selon la ligne B-B de la figure 2A, c'est-à-dire une vue de dessus du composant sans ses métallisations. Dans cet exemple, les régions P1-1 à P1-n sont disposées selon deux lignes parallèles sur les bords du composant, sensiblement de la façon représentée. Alors, la diffusion P2 est répartie en deux régions, éventuellement continues, dont l'une, P2-1, s'étend dans la partie droite de la figure et l'autre, P2-2, entre les deux lignes de régions P1-1 à P1-n. De même, la diffusion N2 est répartie en deux régions, l'une, N2-2, disposée entre les lignes de régions P1-1 à P1-n et l'autre, N2-1, sur la droite de la figure.

Cette structure est susceptible de nombreuses variantes de réalisation qui apparaîtront à l'homme de l'art. Notamment on pourra s'exempter des régions P2-1 et N2-1 pour laisser subsister les seules régions P2-2 et N2-2.

La figure 2C représente une vue de dessus correspondant à la vue en coupe de la figure 2A dans laquelle apparaissent seulement les métallisations. On voit que la métallisation M3 s'étend entre les deux lignes de métallisations M1-1 à M1-n et du côté droit de la figure. Cette extension du côté droit est optionnelle. On peut également prévoir optionnellement une autre métallisation du côté gauche avec des régions correspondantes, symétriques des régions P2-1 et N2-1.

La figure 2D représente une vue de dessus selon la ligne D-D de la figure 2A, c'est-à-dire une vue de dessous retournée de la figure 2A sans la métallisation M2. La région N1 s'étend sensiblement sous toutes les régions P1 et P2 de la face supérieure et la région P3 s'étend sous les régions N2 de la face supérieure. Il existe ainsi une région P3-1 sous la région N2-1 et une région P3-2 sous la région N2-2.

Cette disposition des couches supplémentaires P2, N2 et P3 et plus particulièrement de la métallisation M3 permet ensuite une mise en boîtier simple du composant de la présente invention car des connexions vers la métallisation M3 peuvent être faites vers une cosse quelconque sans compliquer le montage. L'une quelconque des cosses du boîtier pourra simplement être reliée par fil à la métallisation centrale M3 et l'on pourra à partir d'une même puce et d'une même structure de grille de connexion modifier simplement, au gré du client, les cosses qui sont connectées à la métallisation commune M3.

A titre d'exemple, la présente invention a été mise en oeuvre dans une puce comprenant dix huit diodes de protection dans un boîtier S020. La puce avait des dimensions de 1,5 x 3 mm et une épaisseur de 0,35 mm. Les diodes avaient une tension de claquage de 10 volts. Tous les types de conductivité étaient inversés par rapport à ce qui a été décrit précédemment. Le substrat 10 était de type P avec un dopage de 10¹⁷ at./cm³. Les concentrations de surface des couches P1, P2, N2, P3 (de type N, N, P et N) étaient toutes de l'ordre de 10²⁰ at./cm³.

## Revendications

1. Composant semiconducteur intégrant un réseau de diodes de protection (D1-1 à D1-n) formées verticalement dans une plaquette semiconductrice (10) dont des premières électrodes (M1-1 à M1-n) sont disposées selon au moins une rangée sur la face avant du composant et dont les deuxièmes électrodes (M2) correspondent à une métallisation de face arrière du composant, caractérisé en ce qu'il comprend en outre sur ladite face avant une électrode de contact (M3) s'étendant sensiblement sur la longueur de ladite rangée, cette électrode de contact étant reliée à la métallisation de face arrière par deux diodes verticales antiparallèles (D2, D3).

2. Composant semiconducteur selon la revendication 1, dans lequel la plaquette semiconductrice (10) est d'un premier type de conductivité comprenant :
une pluralité de premières zones (P1-1 à P1-n) d'un deuxième type de conductivité formées dans la face avant de la plaquette revêtues des premières électrodes (M1-1 à M1-n) ;
une deuxième zone (P2) du deuxième type de conductivité et une troisième zone (N2) du premier type de conductivité formées dans la face avant de la plaquette, l'électrode de contact (M3) étant en contact avec les deuxième et troisième zones ;
une quatrième zone du premier type de conductivité (N1) formée dans la face arrière en face des premières et deuxième zones ;
une cinquième zone du deuxième type de conductivité (P3) formée dans la face arrière en face de la troisième zone ;
les deuxièmes électrodes (M2) étant en contact avec les quatrième et cinquième zones (N1-P3).

3. Composant semiconducteur selon la revendication 2, caractérisé en ce que les premières zones s'étendent selon au moins une ligne le long d'un bord du composant et en ce que les deuxième et troisième zones s'étendent au moins selon des lignes parallèles à la première ligne.

## Patentansprüche

1. Halbleiterbauteil, in welchem eine Rasteranordnung von in einem Halbleiterplättchen (10) vertikal ausgebildeten Schutzdioden (D1-1 bis D1-n) integriert sind, deren erste Elektroden (M1-1 bis M1-n) in wenigstens einer Reihe auf der Vorder- bzw. Oberseite des Bauteils angeordnet sind und deren zweite Elektroden (M 2) einer Metallisierung der Rück- bzw. Unterseite des Bauteils entsprechen,
**dadurch gekennzeichnet**, daß
das Bauteil auf der genannten Vorderseite eine Kontaktelektrode (M 3) aufweist, welche sich im wesentlichen über die Länge der genannten Reihe erstreckt, wobei diese Kontaktelektrode mit der Rückseitenmetallisierung über zwei antiparallel geschaltete Vertikal-Dioden (D2, D3) verbunden ist.

2. Halbleiterbauteil nach Anspruch 1, bei welchem das Halbleiterplättchen (10) von einem ersten Leitfähigkeitstyp ist und umfaßt:
eine Mehrzahl von in der Vorderseite des Plättchens ausgebildeten und mit ersten Elektroden (M1-1 bis M1-n) überzogenen ersten Zonen (P1-1 bis P1-n) eines zweiten Leitfähigkeitstyps;
eine in der Vorderseite des Plättchens ausgebildete zweite Zone (P2) vom zweiten Leitfähigkeitstyp und dritte Zone (N2) vom ersten Leitfähigkeitstyp, wobei die Kontaktelektrode (M3) in Kontakt mit der zweiten und der dritten Zone steht;
eine in der Rückseite gegenüber der ersten und der zweiten Zone ausgebildete vierte Zone (N1) vom ersten Leitfähigkeitstyp;
sowie eine in der Rückseite gegenüber der dritten Zone ausgebildete fünfte Zone (P3) vom zweiten Leitfähigkeitstyp;
wobei die zweiten Elektroden (M2) in Kontakt mit den vierten und fünften Zonen (N1-P3) stehen.

3. Halbleiterbauteil nach Anspruch 2, dadurch gekennzeichnet, daß die ersten Zonen sich entlang wenigstens einer Linie entlang einem Rand des Bauteils erstrecken und daß die zweite und die dritte Zone sich wenigstens längs zu der ersten Linie parallelen Linien erstrecken.

## Claims

1. A semiconductor component integrating an array of protection diodes (D1-1 to D1-n) that are vertically disposed in a semiconductor wafer (10), the first electrodes (P1-1 to P1-n) of the diodes being disposed along at least one row on the top surface of the component, the second electrodes (M2) of said diodes, corresponding to the bottom surface of the component characterized in that it further includes on the front surface a contact electrode (M3) that extends substantially throughout the length of said row, said contact electrode being connected to the bottom surface metallization through two antiparallel vertical diodes (D2, D3).

2. A semiconductor component according to claim 1, wherein the semiconductor wafer (10) is of a first conductivity type, including:
a plurality of first regions (P1-1 to P1-n), of a second conductivity type, formed in the top surface of the wafer and coated with first electrodes (M1-1 to M1-n);
a second region (P2), of the second conductivity type, and a third region (N2), of the first conductivity type, formed in the top surface of the wafer, the contact electrode (M3) contacting the second and third regions;
a fourth region (N1), of the first conductivity type, formed in the bottom surface and facing the first and second regions;
a fifth region (P3), of the second conductivity type, formed in the bottom surface and facing the third region;
the second electrodes (M2) contacting the fourth and fifth regions (N1-P3).

3. The semiconductor component of claim 2, characterized in that the first regions extend at least along one line along a side of the component, and the second and third regions extend at least along lines that are parallel with the first line.
